# FASCICULE DE BREVET EUROPEEN

(11) **EP 0 444 986 B1**
(45) Date de publication et mention de la délivrance du brevet: **04.09.1996**
(21) Numéro de dépôt: 91400280.3
(22) Date de dépôt: 06.02.1991
(51) Int. Cl.: H03K 3/53

(54) **Dispositif d'alimentation électrique pour un ou plusieurs lasers à vapeur métallique**
Elektrische Spannungsversorgungsvorrichtung für einen oder mehrere Metalldampflaser
Electrical power supply device for one or several metal vapor lasers

(30) Priorité: 08.02.1990 FR 9001455
(43) Date de publication de la demande: 04.09.1991
(73) Titulaire: COMMISSARIAT A L'ENERGIE ATOMIQUE, 75015 Paris (FR)
(72) Inventeur: Chaudanson, Bernard, F-26700 La Garde Adhemar (FR)
(74) Mandataire: Signore, Robert

(56) Documents cités:
- EP-A- 0 072 153
- US-A- 3 363 184
- US-A- 3 749 975

## Description

La présente invention a pour objet un dispositif d'alimentation électrique pour un ou plusieurs lasers à vapeur métallique. Elle s'applique notamment à l'alimentation électrique simultanée d'un grand nombre de lasers à vapeur métallique.

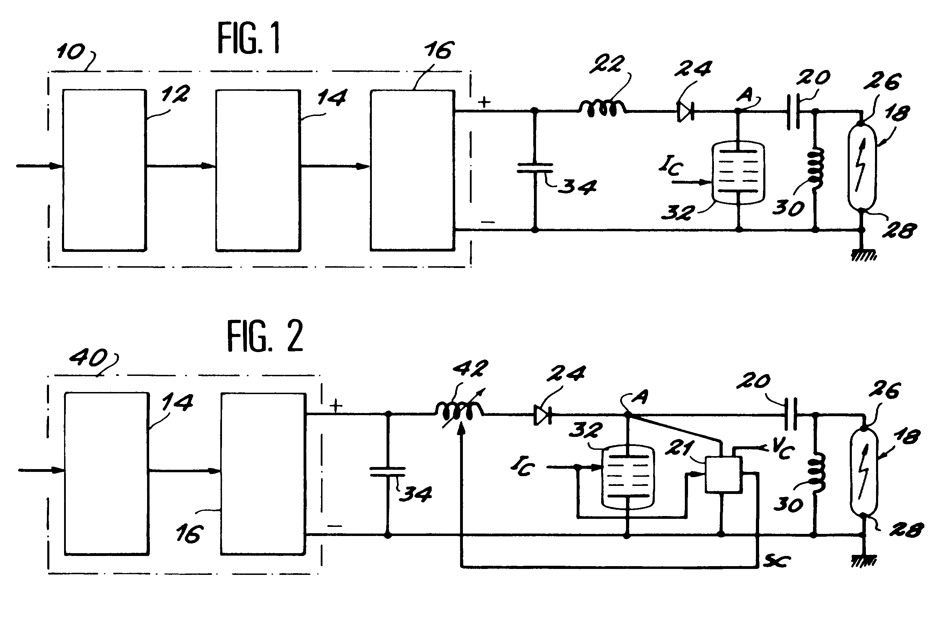

En référence à la figure 1, on décrit maintenant un dispositif usuel pour alimenter un laser à vapeur métallique.

De manière connue, la tension alternative délivrée par le réseau, 380 V triphasé par exemple, est convertie par un convertisseur 10 en une tension continue mais d'amplitude réglable à volonté.

Le convertisseur 10 comporte un module de réglage 12 à autotransformateur variable et délivrant une tension alternative d'amplitude variable. Un transformateur élévateur de rapport de transformation fixe 14 transforme cette tension alternative variable en une haute tension alternative d'amplitude variable. Un circuit de redressement et de filtrage 16 permet la transformation de la haute tension alternative en une haute tension continue d'amplitude variable.

Cette haute tension continue délivrée entre les sorties (+) et (-) du convertisseur 10 est transformée en tension impulsionnelle délivrée sur les électrodes du tube 18 du laser à vapeur métallique.

La tension impulsionnelle est produite grâce à la décharge d'un condensateur de charge 20.

Une bobine d'induction 22, d'inductance fixe, est connectée à la sortie (+) du convertisseur et d'autre part, à une électrode d'une diode 24. L'autre électrode de la diode 24 est connectée en un point A à une armature du condensateur 20.

L'autre armature du condensateur 20 est connectée à une première électrode 26 du tube 18. L'autre électrode 28 du tube 18 est portée au potentiel de masse.

Une bobine d'induction 30 dont l'inductance est d'environ 50 nH est connectée aux électrodes 26, 28 du tube 18 en un montage parallèle. Cette bobine 30, dont l'inductance est très supérieure à celle du tube 18 permet la charge du condensateur 20.

Une impulsion électrique de commande Ic provoque la fermeture brutale d'un interrupteur commandable 32, un thyratron par exemple, relié au point A d'une part et à la sortie (-) du convertisseur 10 d'autre part. La fermeture de l'interrupteur 32 provoque la décharge du condensateur 20 à travers le tube 18.

Un condensateur 34 connecté, en un montage parallèle aux sorties (+) et (-) du convertisseur 10 permet d'éviter la chute de tension due à l'appel de courant lors de la recharge du condensateur 20 (fait office de réservoir d'énergie).

Le fait que l'amplitude de crête de l'impulsion de tension soit réglable permet l'adaptation de la quantité d'énergie fournie au tube 18 du laser en fonction des caractéristiques particulières de ce tube 18. Les effets du vieillissement, la quantité de métal ou d'autres paramètres encore font que les tubes différent les uns des autres.

Le convertisseur d'un tel dispositif connu est réglé pour un laser donné et ne peut servir à l'alimentation simultanée de plusieurs.

Le but de la présente invention est de fournir un dispositif d'alimentation dont le convertisseur peut être mis en commun pour un grand nombre de lasers.

Pour cela, l'invention préconise la conversion de la tension alternative délivrée par le réseau en une tension continue d'amplitude fixe, le réglage de l'amplitude de crête de la tension impulsionnelle s'effectuant au niveau du circuit de charge du condensateur de charge.

Cela permet d'une part l'augmentation du rendement électrique de conversion et d'autre part, la réduction du coût et des volumes du dispositif d'alimentation.

Dans le cas de l'utilisation d'un seul convertisseur pour un ensemble de lasers, ce dernier peut être isolé dans un local séparé et relié aux lasers par de simples liaisons coaxiales.

On connaît déjà, par le document US-A-3749975, un générateur d'impulsions électriques et, par le document US-A-3363184, un dispositif d'alimentation électrique correspondant au préambule de la revendication 1.

De façon précise, la présente invention concerne un dispositif d'alimentation électrique conformément à la revendication 1.

Selon une première variante de réalisation, ladite bobine à induction variable comporte un noyau magnétique mobile longitudinalement dans l'axe de la bobine.

Selon une seconde variante de réalisation, ladite bobine à induction variable comporte deux bobinages mobiles l'un par rapport à l'autre et reliés en série de manière à présenter une inductance mutelle dépendant de leur position respective.

Selon une troisième variante de réalisation, ladite bobine à induction variable comporte un noyau ferromagnétique introduit dans un bobinage, un enroulement de contrôle entourant le noyau ferromagnétique, des moyens pour faire circuler un courant dans l'enroulement de contrôle de manière à faire varier l'induction du noyau.

De toute façon, les caractéristiques et avantages de l'invention apparaîtront mieux après la description qui suit donnée à titre explicatif et nullement limitatif. Cette description se réfère à des dessins annexés sur lesquels :
- la figure 1, déjà décrite et relative à l'art antérieur, représente schématiquement un dispositif d'alimentation électrique d'un laser à vapeur métallique,
- la figure 2 représente schématiquement un dispositif d'alimentation électrique conforme à l'invention,
- les figures 3A et 3B représentent schématiquement une réalisation d'une bobine à induction mutuelle variable en coupe et selon l'axe AA de la coupe,
- la figure 4 représente schématiquement une réalisation d'une bobine à induction mutuelle variable,
- la figure 5 représente schématiquement une autre réalisation d'une bobine à induction variable,
- la figure 6 représente schématiquement différentes courbes de charge d'un dispositif d'alimentation électrique conforme à celui de la figure 2,
- la figure 7 représente schématiquement un dispositif d'asservissement utilisé dans un dispositif d'alimentation conforme à l'invention,
- la figure 8 représente schématiquement un dispositif d'alimentation électrique conforme à l'invention dans le cas de l'alimentation simultanée de plusieurs lasers.

La figure 2 représente schématiquement un dispositif d'alimentation électrique pour l'alimentation d'un laser à vapeur métallique. Un convertisseur 40 connecté au réseau et donc alimenté par une tension alternative de 380 V triphasée délivre une haute tension continue d'amplitude fixe entre ses sorties (+) et (-). Ce convertisseur 40 comporte un transformateur-élévateur 14 ayant un rapport de transformation fixe connecté à un circuit de redressement et de filtrage 16.

Dans ce mode de réalisation, la haute tension continue est transformée en tension impulsionnelle par un circuit présentant une pente de charge variable. Ce circuit comporte une bobine 42 à induction variable connectée d'une part à la sortie (+)du convertisseur 40 et d'autre part à une électrode d'une diode 24.

L'autre électrode de la diode 24 est connectée en un point A à une armature d'un condensateur de charge 20. L'autre armature du condensateur 20 est reliée à l'électrode 26 du tube 18 du laser.

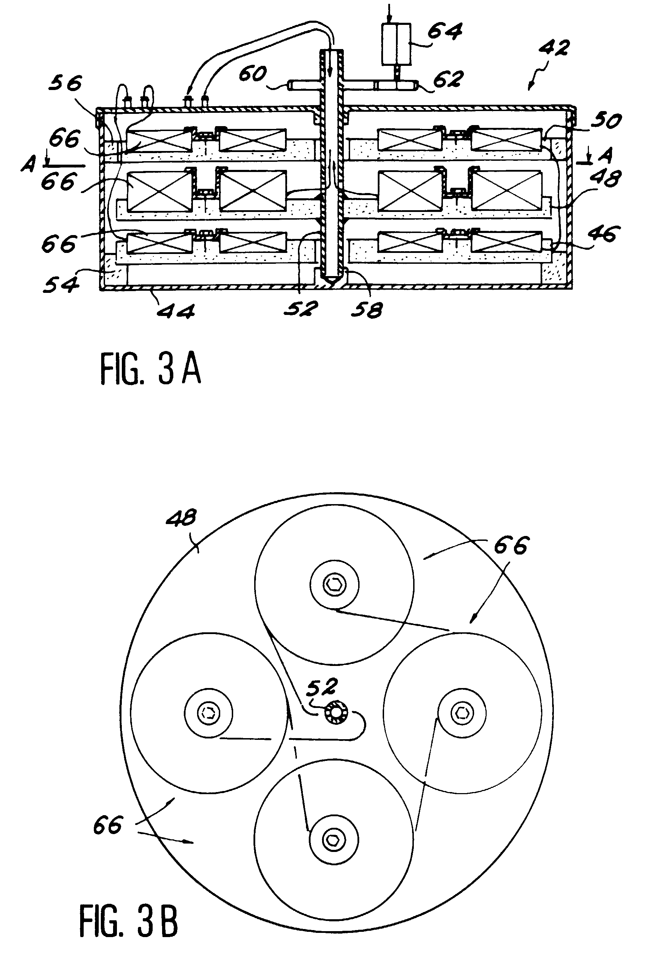

En référence aux figures 3A et 3B , on décrit maintenant un premier mode de réalisation d'une bobine à induction variable.

Une cuve à circulation d'huile cylindrique 44 contient trois disques isolants 46, 48, 50 parallèles, percés en leur centre pour autoriser le passage d'un axe 52 isolant et creux. Les disques 46 et 50 sont fixés à des couronnes 54, 56 solidaires de la cuve 44. Le disque 48 central est solidaire de l'axe 52 qui s'emboîte dans un palier 58 soudé ou collé au fond de la cuve 44. A l'extérieur de la cuve 44, l'axe 52 est muni d'une couronne dentée emboîtée dans un pignon 62 solidaire de l'axe d'un moteur 64.

Chaque disque 46, 48, 50 supporte quatre bobinages plats 66 disposés symétriquement par rapport à leurs centres comme on peut le voir sur la vue de face du disque 48 (figure 3B). Chaque bobinage 66 est enroulé dans un sens inverse par rapport aux enroulements des bobinages voisins. Les quatre bobinages 66 d'un disque sont connectés entre eux dans un montage en série. Les bobinages 66 des disques 46 et 50 sont superposés, les bobinages se faisant face étant enroulés dans le même sens. De plus, les bobinages 66 des disques 46 et 50 sont connectés en série entre eux.

Les bobinages 66 du disque central 48 comportent deux fois plus d'enroulements que les bobinages 66 des disques 46, 50. Les fils d'arrivée et de sortie de courant des bobinages du disque central 48 parcourent l'axe creux 52 et sont raccordés sur des isolants placés à l'extérieur de la cuve 44.

Les variations d'inductance sont obtenues en modifiant, par rotation, la position du disque central 48. L'inductance maximum est obtenue lorsque les bobinages supportés par le disque central 48 sont superposés aux bobinages des disques 46 et 50, les enroulements des bobinages en vis-à-vis étant dans le même sens. L'inductance minimum est obtenue en faisant pivoter de 90° le disque central 48 à partir de la position d'inductance maximum.

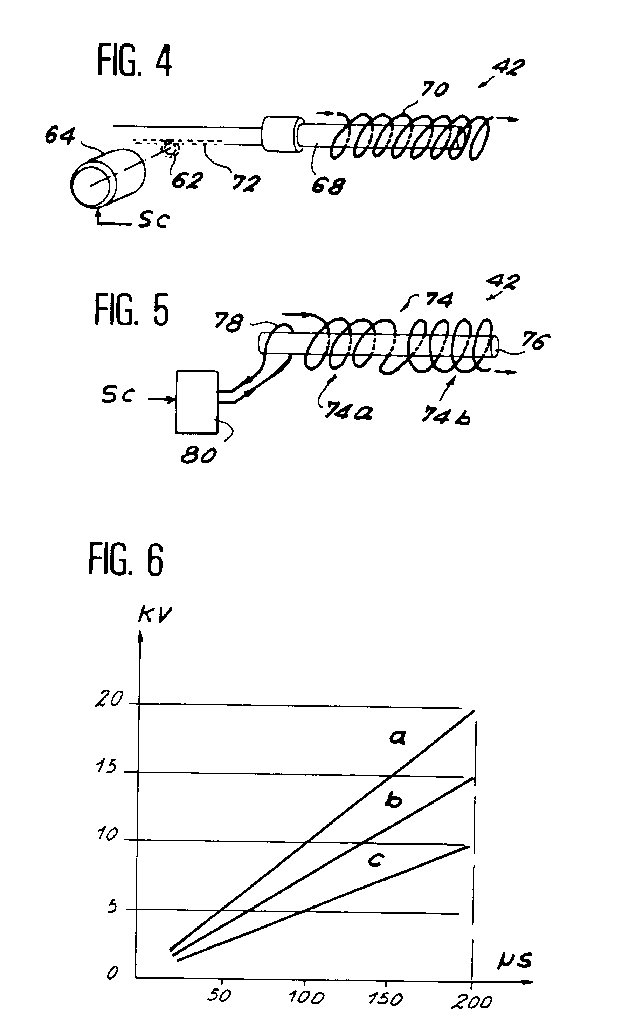

La figure 4 représente schématiquement un autre mode de réalisation d'une bobine à inductance variable. La variation d'inductance est obtenue en réglant la longueur de pénétration d'un barreau magnétique 68 à l'intérieur du bobinage 70.

Le barreau 68 est solidaire d'une crémaillère 72 emboitée dans un pignon 62 placé à l'extrémité de l'axe d'un moteur 64. De cette manière, le barreau peut être entraîné en translation selon l'axe longitudinal du bobinage 70.

La figure 5 représente schématiquement un autre mode de réalisation d'une bobine à inductance variable. La variation d'inductance est obtenue en modifiant le coefficient d'induction d'un barreau magnétique 76 placé à l'intérieur d'un bobinage 74 et selon son axe longitudinal. Un enroulement de contrôle 78 relié à des moyens 80 pour délivrer un courant entoure le barreau magnétique 76. Le coefficient d'induction du barreau magnétique 76 et donc l'inductance de la bobine 74 dépendent de l'intensité du courant traversant l'enroulement de contrôle 78.

Dans cette réalisation, le bobinage 74 comporte deux séries de spires 74a et 74b enroulées dans des sens différents. De cette manière, on annule l'effet "transformateur" du bobinage et, par conséquent, on obtient une protection contre d'éventuelles impulsions de tension provenant de la réflexion de l'énergie délivrée au tube 18 du laser, les impédances du tube 18 et du circuit d'alimentation n'étant pas parfaitement adaptées.

La figure 6 représente schématiquement différentes courbes de charge relatives à un dispositif d'alimentation électrique conforme à celui de la figure 2. Les courbes a, b, c correspondent respectivement à des inductances de 400 mH, 1000 mH et 2000 mH. Dans cet exemple, la capacité du condensateur de charge 20 est de 8nF et la fréquence de répétition des tirs au laser est de 5 kHz (un tir toutes les 200 microsecondes). La décharge a lieu approximativement en 200 ns, ce qui revient à dire qu'à l'échelle adoptée sur la figure, la courbe de décharge est sensiblement verticale.

On constate que suivant l'inductance L de la bobine d'induction 42, la pente des courbes de charge varie. La tension atteinte au bout de 200 microsecondes entre le point A et la masse est fonction de cette pente. La puissance du faisceau laser est directement fonction de cette tension. Ainsi, grâce à la connaissance des caractéristiques du tube 18, celles-ci étant fournies par le constructeur, on peut régler l'inductance de la bobine 42 de manière à obtenir la puissance lumineuse désirée.

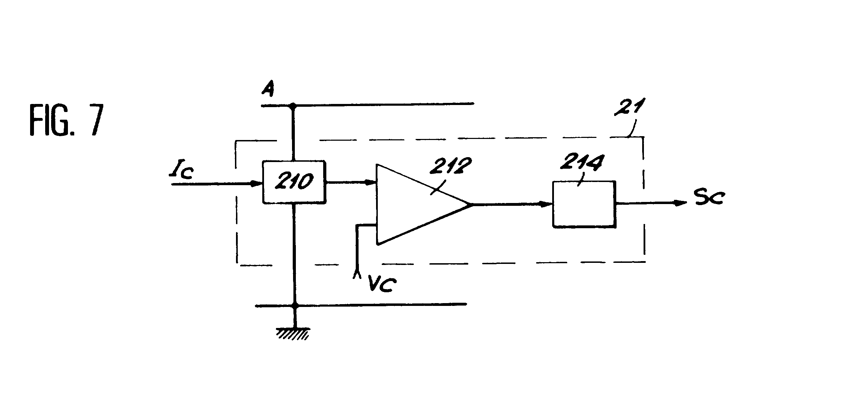

Par ailleurs, ce réglage peut être automatisé grâce à un dispositif d'asservissement référencé 21 sur la figure 2. Ce dispositif d'asservissement est décrit plus en détail ci-dessous en référence à la figure 7.

La tension délivrée entre le point A et la masse est asservie à une valeur de consigne Vc déterminée par l'utilisateur. Commandé par le signal Ic de déclenchement du thyratron 32, un voltmètre 210 mesure la tension appliquée entre le point A et la masse. Ce voltmètre effectue une moyenne sur une centaine de mesures par exemple et délivre sur une sortie un signal indiquant la tension moyenne entre le point A et la masse. Cette tension moyenne est comparée à la valeur de consigne Vc par un comparateur 212. Ce dernier délivre un signal, fonction de la comparaison, sur une entrée d'un dispositif de commande 214 apte à délivrer sur une sortie un signal de commande Sc. Le signal Sc appliqué, selon la variante de réalisation retenue, sur une entrée du moteur 64 ou sur une entrée du générateur de courant 80 permet de faire varier l'inductance de la bobine 42 de manière à obtenir une tension égale à la valeur de consigne lors du déclenchement du thyratron.

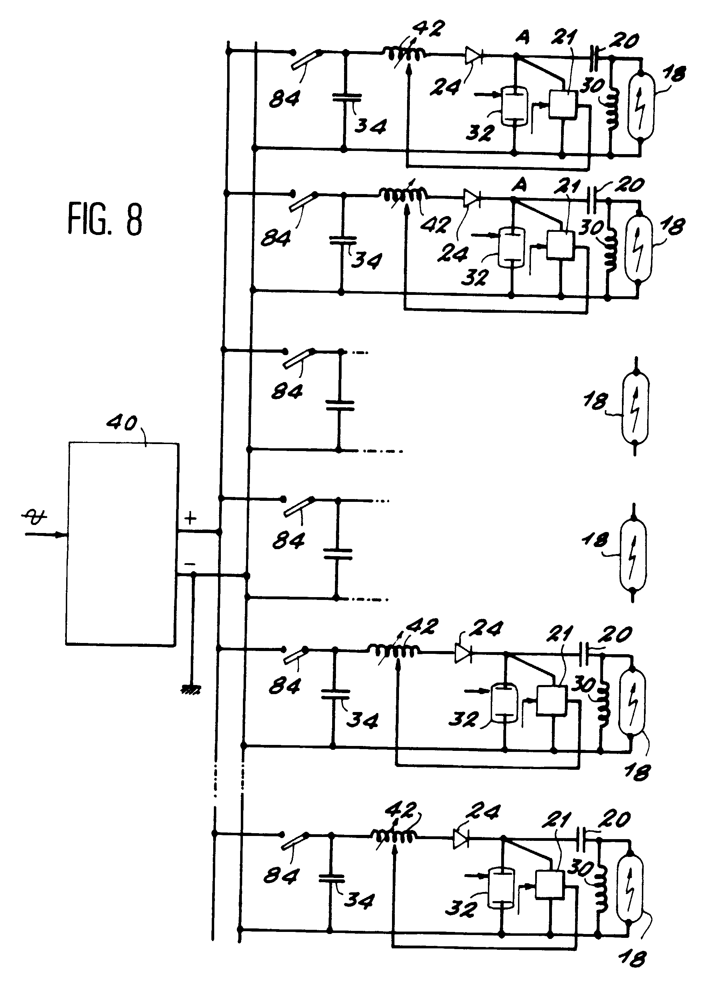

La figure 8 représente schématiquement un dispositif conforme à l'invention appliqué à l'alimentation électrique de plusieurs lasers.

Un convertisseur 40 unique convertit la tension alternative du réseau en une haute tension continue délivrée entre ses sorties (+) et (-).

Chacun des tubes 18 est relié à un moyen pour délivrer une tension impulsionnelle d'amplitude maximum réglable. Ainsi, en fonction des caractéristiques propres à chaque tube 18, la tension impulsionnelle est réglée de manière à obtenir la puissance désirée pour chaque faisceau laser.

Dans l'exemple représenté, sur la figure 8, chacun des moyens pour délivrer une tension impulsionnelle est conforme au mode de réalisation de la figure 2. Ces moyens sont tous reliés dans un montage parallèle aux sorties (+) et (-) du convertisseur 40. Chacun de ces moyens est muni d'un interrupteur 84 permettant la mise en ou hors service du tube 18 auquel ils sont connectés.

Dans un dispositif conforme à l'invention, le réglage de l'amplitude maximum de la tension impulsionnelle est indépendant de la conversion de la tension alternative en une tension continue.

Pour l'alimentation électrique de plusieurs lasers, un seul convertisseur est alors nécessaire. Ceci permet d'aumgenter le rendement électrique de l'ensemble de conversion et de réduire le coût et le volume de l'alimentation électrique. D'autre part, le convertisseur peut être éloigné des lasers sans que cela pose de problème particulier.

## Revendications

1. Dispositif d'alimentation électrique, notamment pour un ou plusieurs lasers à vapeur métallique, comprenant :
un unique convertisseur (40) d'une tension alternative en une tension continue d'amplitude fixe, et
au moins un moyen pour délivrer, à partir de ladite tension continue, une tension impulsionnelle d'amplitude maximum réglable, caractérisé en ce que :
ce moyen comporte un interrupteur commandable (32) connecté à un circuit de charge d'énergie électrique présentant une pente de charge variable et apte à décharger cette énergie à la suite de la fermeture dudit interrupteur commandable (32) et
en ce que la charge de l'énergie électrique s'effectue dans un condensateur de charge (20) connecté en un point A à une électrode d'une diode (24), l'autre électrode de cette diode (24) étant connectée à une bobine à induction variable (42) qui permet la variation de la pente de charge du circuit de charge et dont l'inductance est réglée automatiquement.

2. Dispositif selon la revendication 1, caractérisé en ce que ladite bobine à induction variable (24) comporte au moins deux bobinages (66) mobiles l'un par rapport à l'autre et reliés en série de manière à présenter une inductance mutuelle dépendant de leur position respective.

3. Dispositif selon la revendication 1, caractérisé en ce que ladite bobine à induction variable (42) comporte un noyau magnétique (68) mobile longitudinalement selon l'axe de la bobine.

4. Dispositif selon la revendication 1, caractérisé en ce que ladite bobine à induction variable (42) comporte un noyau ferromagnétique (76) introduit dans un bobinage (74), un enroulement de contrôle (78) entourant le noyau ferromagnétique (76), des moyens (80) pour faire circuler un courant dans l'enroulement de contrôle (78) de manière à faire varier l'induction du noyau.

5. Dispositif selon la revendication 1, caractérisé en qu'il comprend, en plus dudit convertisseur (40), plusieurs moyens pour délivrer une tension impulsionnelle, chaque moyen étant relié à ce convertisseur.

## Patentansprüche

1. Elektrische Versorgungsvorrichtung, insbesondere für einen oder mehrere Metalldampflaser, umfassend:
einen einzigen Umformer (40) einer Wechselspannung in eine Gleichspannung mit fester Amplitude, und
wenigstens eine Einrichtung, die aus dieser Spannung eine Impulsspannung mit einer regelbaren maximalen Amplitude macht,
**dadurch gekennzeichnet**,
daß diese Einrichtung einen steuerbaren Schalter (32) umfaßt, verbunden mit einer Ladeschaltung elektrischer Energie, die eine veränderliche Ladesteilheit aufweist und diese Energie in der Folge der Schließung dieses steuerbaren Schalters (32) entladen kann, und
dadurch, daß die Ladung der elektrischen Energie in einem Ladungskondensator (20) erfolgt, verbunden in einem Punkt A mit einer Elektrode einer Diode (24), die verbunden ist mit einer Spule mit variabler Induktion (42), die die Veränderung der Ladesteilheit der Ladeschaltung ermöglicht und deren Induktanz automatisch geregelt wird.

2. Vorrichtung nach Anspruch 1, dadurch gekennzeichnet, daß besagte Spule mit variabler Induktion (24) wenigstens zwei Spulen (66) umfaßt, untereinander beweglich und in Serie geschaltet, um eine von ihrer jeweiligen Lage abhängige gegenseitige Induktanz aufzuweisen.

3. Vorrichtung nach Anspruch 1, dadurch gekennzeichnet, daß besagte Spule mit variabler Induktion (42) einen in Längsrichtung entsprechend der Spulenachse beweglichen Magnetkern (68) aufweist.

4. Vorrichtung nach Anspruch 1, dadurch gekennzeichnet, daß die Spule mit variabler Induktion (42) einen in eine Wicklung (74) eingeführten ferromagnetischen Kern (76) umfaßt, wobei eine Steuerumschlingung (78) den ferromagnetischen Kern (76) umgibt, sowie Einrichtungen (80), die in der Steuerumschlingung (78) einen Strom fließen lassen, um die Induktion des Kerns zu verändern.

5. Vorrichtung nach Anspruch 1, dadurch gekennzeichnet, daß sie zusätzlich zu dem genannten Umformer (40) mehrere Einrichtungen zur Lieferung einer Impulsspannung umfaßt, wobei jede Einrichtung mit diesem Umformer verbunden ist.

## Claims

1. Electrical supply device, in particular for one or more metal-vapour lasers, comprising:
- a single converter (40) for converting an AC voltage into a DC voltage of fixed amplitude, and
- at least one means for delivering, using the said DC voltage, a pulsed voltage of adjustable maximum amplitude, characterized in that:
this means comprises a controllable switch (32) connected to an electrical energy charging circuit having a variable charging slope and capable of discharging this energy subsequent to closure of the said control switch (32), and in that the electrical energy is charged in a charging capacitor (20) connected at a point A to one electrode of a diode (24), the other electrode of this diode (24) being connected to a variable induction coil (42) which makes it possible to vary the charging slope of the charging circuit and the inductance of which is adjusted automatically.

2. Device according to Claim 1, characterized in that the said variable induction coil (24) comprises at least two coils (66) which can be moved relative to one another and are connected in series so as to have a mutual inductance which depends on their respective position.

3. Device according to Claim 1, characterized in that the said variable induction coil (42) comprises a magnetic core (68) which can be moved longitudinally along the axis of the coil.

4. Device according to Claim 1, characterized in that the said variable induction coil (42) comprises a ferromagnetic core (76) introduced into a wound coil (74), a control winding (78) surrounding the ferromagnetic coil (76), and means (80) for causing a current to flow in the control winding (78) so as to vary the induction of the core.

5. Device according to Claim 1, characterized in that it comprises, in addition to the said converter (40), a plurality of means for delivering a pulsed voltage, each means being connected to this converter.
